# EUROPEAN PATENT APPLICATION

(11) **EP 4 727 266 A2**
(43) Date of publication of application: **15.04.2026**
(21) Application number: 26153994.4
(22) Date of filing: 26.01.2026
(51) Int. Cl.: H05K 1/02, H05K 1/189, H05K 3/46, H05K 1/03

(54) **ANTI-INTERFERENCE FLEXIBLE CIRCUIT BOARD OF AUDIO APPARATUS WITH CAMERA FUNCTION, METHOD, AND APPARATUS**

(30) Priority: 23.12.2025 CN 202511957043
(71) Applicant: Shenzhen RB-LINK Intelligent Technology Co., Ltd, Shenzhen (CN)
(72) Inventor: HE, Wei, Shenzhen, Guangdong (CN); MA, Zhiyun, Shenzhen, Guanggong (CN)
(74) Representative: Winter, Brandl - Partnerschaft mbB

(57) **Abstract**

An anti-interference flexible circuit board for an audio apparatus with a camera comprises an integrated ribbon multilayer structure. An outer conductive layer includes a differential signal line group for digital video transmission and a main clock line, covered by an electromagnetic shielding film to form a shielding cavity. The flexible circuit board further integrates an analog audio drive line group and an independent microphone ground line physically isolated from a main ground line network, connecting only at a terminal portion or a pad position. A package body provides outer-layer protection. Through this layered wiring and shielding isolation, common-ground interference in hybrid transmission of high-speed digital and analog signals within narrow spaces is effectively reduced.

## Description

### FIELD OF TECHNOLOGY

The present disclosure relates to the technical field of application specific integrated circuits, and in particular, to an anti-interference flexible circuit board of an audio apparatus with a camera function, a method, and the apparatus. The anti-interference flexible circuit board and its laminated structure according to the present disclosure are applicable to an application specific integrated circuit (ASIC) integrated into a wearable audio apparatus with a camera function, and its peripheral interconnection structure. The structural design is specially optimized for the hybrid transmission requirements of high-speed digital video signals, analog audio signals, and control signals, and particularly relates to a flexible circuit board structure that provides stable signal transmission, electromagnetic shielding, and reliable interconnection for the application specific integrated circuit in a narrow space.

### BACKGROUND

Bone conduction headphones, due to their "open-ear" characteristic, allow users to perceive ambient sounds while receiving audio information, making them widely used in sports, outdoor, and safety-sensitive scenarios. A typical prior art, as disclosed in Chinese Patent CN205336486U (Bone Conduction Wireless Headphones), generally includes a rear-hanging assembly, earhook assemblies, and pod assemblies disposed at the ears.

In existing bone conduction headphone products, electrical connections between a battery, a Bluetooth circuit board, and an audio transducer are typically achieved using multiple independent round wires. For example, in current solutions, a rear-hanging wire, a left wire, and a right wire are often passed through a narrow gap between a metal support strip and a silicone sleeve to achieve power supply and audio signal transmission. Such wire harness structures can meet the basic requirements for low-speed audio signals and direct current power supply, but their design does not take into account application scenarios involving high-speed data transmission and coexistence of multiple signal types.

With the advancement of wearable technology, the market demand for combining "first-person view (FPV) shooting" functionality with "high-quality audio experience" continues to grow. However, further integrating a camera function into the existing form factor and wearing structure of bone conduction headphones presents several technical challenges, mainly in the following aspects.

First, in terms of space constraints and wiring, the earhook assemblies of the bone conduction headphones are typically designed as slender structures with a diameter of often less than 5 mm, to balance wearing comfort and aesthetic requirements. Existing solutions using round enameled wires, twisted wires, or parallel wire harnesses are only applicable to low-speed signal and power transmission. When a camera module is introduced, additional lines for transmitting high-speed digital video signals, such as differential signal lines for MIPI interfaces, need to be arranged. If conventional wire harness methods are still used, the overall volume of the wire harness will increase significantly, making it difficult to arrange in the existing earhook cavity and thus posing challenges to structural implementation.

Secondly, a more critical issue lies in electromagnetic interference and common-ground noise. The camera module transmits high-speed and high-frequency digital pulse signals during operation, and rapid edge transitions of the signals generate significant high-frequency electromagnetic radiation. In contrast, the audio transducer requires high-current analog drive signals, while the microphone outputs very low-amplitude analog audio signals. In a narrow linear space, if the above signal lines with different characteristics are arranged in parallel, the electromagnetic noise generated by the high-speed digital signals can easily couple into the analog audio lines through crosstalk, resulting in noticeable background noise or artifacts in audio perception.

In addition, existing designs generally employ a common ground loop. When the audio transducer operates, its high current flowing through the ground line may cause fluctuations in ground potential, and high-frequency ground noise generated by a digital circuit of a camera is also superimposed onto the same ground network. Such common-ground interference caused by ground impedance may not only degrade the sound pickup quality of the microphone but also adversely affect the stability of video signals.

Furthermore, in terms of mechanical reliability and protective performance, in the prior art, wires are mostly loosely arranged inside the silicone sleeve, lacking clear hierarchical fixation and structural protection. When a slidably adjustable camera structure is introduced, connecting wires need to repeatedly withstand push-pull and bending stresses, making conventional wires prone to fatigue fracture at joints. Moreover, transition regions between wires and hard housings are difficult to seal reliably, making it challenging for the entire apparatus to meet higher-level protection requirements for waterproofing and sweat resistance.

In summary, there is still a lack of an integrated interconnection solution in the prior art that can, under extremely limited space conditions (such as a connection region with a width of no more than 12 mm), achieve both high-speed video signal transmission and high-current audio drive, effectively isolate electromagnetic interference and common-ground noise, and adapt to dynamic sliding structures while providing good mechanical and protective performance.

### SUMMARY

Bone conduction headphones in the prior art typically use multiple round wire harnesses to connect a battery, a mainboard, and a speaker. However, as wearable devices become more multifunctional, integrating a camera into bone conduction headphones poses severe challenges to existing wiring methods: on one hand, the internal space of the earhook assembly is extremely narrow (typically less than 5 mm in width), making it difficult to accommodate the complex wire harnesses required for transmitting the high-speed digital video signals; and on the other hand, the high-frequency radiation from the high-speed digital video signals (such as MIPI signals) can easily cause severe electromagnetic interference with the high-current analog drive signals of bone conduction and the weak analog signals from the microphone, resulting in increased audio background noise and reduced signal-to-noise ratio. In addition, if the camera module is designed with a sliding adjustment function, conventional wire connection methods are highly prone to fatigue fracture under repeated pushing and pulling, and it is difficult to achieve a high level of waterproof sealing at the joints between the various components. Therefore, an objective of the present disclosure is to provide an anti-interference flexible circuit board of an audio apparatus with a camera function, a method for fabricating the anti-interference flexible circuit board, and the headphones, aiming to solve the common-ground interference problem arising from hybrid transmission of high-speed digital signals and analog signals in a narrow space, and to ensure signal integrity while meeting structural requirements for dynamic bending and waterproof sealing.

To achieve the above objective, the present disclosure provides the following technical solutions:
1. An anti-interference flexible circuit board of an audio apparatus with a camera function is provided, including: a flexible conductive laminated structure, configured as an integrated flexible ribbon structure and divided into a mounting portion and a connecting portion in a length direction, where the connecting portion has a width of 2 mm to 12 mm; the flexible conductive laminated structure includes: a first conductive layer and a second conductive layer that serve as outer signal layers, and a core layer located between the first conductive layer and the second conductive layer, where the first conductive layer, the core layer, and the second conductive layer are separated by an insulating medium; and the first conductive layer and/or the second conductive layer is provided with a differential signal line group and a main clock line, the differential signal line group is used to transmit a digital video signal, the main clock line is used to synchronize clock frequencies of a master device and a slave device, and a reference potential layer is formed in at least a part of the core layer; an electromagnetic shielding film, covering outer surfaces of the first conductive layer and the second conductive layer, such that in at least a part of the connecting portion, the core layer, the differential signal line group, and the main clock line are together wrapped in a shielding cavity formed by the electromagnetic shielding film; and a package body, disposed on the connecting portion to enclose the flexible conductive laminated structure and form outer-layer protection, where the flexible conductive laminated structure is further provided with an analog audio drive line group and an electrically independent microphone ground line, the analog audio drive line group is used to transmit a drive current to an audio transducer, and the microphone ground line is physically isolated from a main ground line network of the flexible conductive laminated structure and electrically connected to the main ground line network only at a terminal portion and/or a pad position.
2. A method for fabricating the above anti-interference flexible circuit board is provided, including the following steps: providing a core layer, where a reference potential layer is formed in at least a part of the core layer; forming a first conductive layer and a second conductive layer on an upper surface and a lower surface of the core layer respectively, where the first conductive layer and the second conductive layer are physically isolated from the core layer by an insulating medium to form a flexible conductive laminated structure, and patterning the first conductive layer and/or the second conductive layer to form a differential signal line group and a main clock line; attaching an electromagnetic shielding film to outer surfaces of the first conductive layer and the second conductive layer, thereby forming an electromagnetic shielding cavity that wraps the core layer, the differential signal line group, and the main clock line; cutting the flexible conductive laminated structure covered with the electromagnetic shielding film into an integrated flexible ribbon structure, and dividing the flexible conductive laminated structure into a mounting portion and a connecting portion in a length direction, where the connecting portion has a width of 2 mm to 12 mm; and forming a package body at the connecting portion to enclose the flexible conductive laminated structure and form outer-layer protection, where the flexible conductive laminated structure is further provided with an analog audio drive line group and an electrically independent microphone ground line, the analog audio drive line group is used to transmit a drive current to an audio transducer, and the microphone ground line is physically isolated from a main ground line network of the flexible conductive laminated structure.
3. An audio apparatus with a camera function is provided, including: a rear-hanging assembly, configured to encircle a rear side of the head of a user; earhook assemblies, connected to both ends of the rear-hanging assembly respectively, where each of the earhook assemblies has a proximal end connected to the rear-hanging assembly and a distal end extending above an auricle of the user and pointing to a facial region of the user; at least one pod assembly, physically connected to the distal end of the earhook assembly, where the pod assembly has a hard housing with an audio transducer accommodated inside; a camera module, slidably connected to an outer side of the pod assembly and configured to acquire a video signal from a first-person view and allow the user to adjust a shooting field of view; and a main control circuit board, disposed in an internal cavity of the earhook assembly, where an anti-interference flexible circuit board serves as a flexible bridging member connecting the earhook assembly and the pod assembly, a connecting portion of the anti-interference flexible circuit board is threaded through the earhook assembly and is inserted into the main control circuit board, a mounting portion of the anti-interference flexible circuit board extends into the hard housing of the pod assembly and is electrically connected to the camera module, and a package body of the anti-interference flexible circuit board encloses and seals a joint between the distal end of the earhook assembly and the hard housing of the pod assembly to form outer-layer protection; and the anti-interference flexible circuit board serves as a primary hybrid signal transmission channel for simultaneously transmitting the video signal from the camera module and an audio signal from the audio transducer.

The technical solutions provided by the present disclosure have the following beneficial effects:
1. Excellent anti-interference performance: through the unique layered design, the high-speed digital video signals (differential lines/clock lines) prone to radiation are arranged on the outer layers and adjacent to the electromagnetic shielding film, and the sensitive analog audio signals are arranged in the inner core layer. A Faraday cage formed by the shielding film effectively confines high-frequency radiation, and the core layer serves as a reference ground plane to further isolate signal crosstalk.
2. Solution to common-ground interference: for the coexistence of high-current drive and weak microphone signals unique to bone conduction headphones, the physically isolated independent microphone ground line is designed in the present disclosure and is connected only at the endpoint (e.g., the terminal portion or the pad region), thus effectively eliminating ground loop noise and ensuring the purity of recording and communication.
3. Integration in an extremely narrow space: in the present disclosure, multiple complex signals are integrated into the integrated flexible ribbon structure with a width of not greater than 3.5 mm, thus successfully solving the spatial problem of simultaneously transmitting the audio and video signals in the slender earhook assemblies, and replacing conventional bulky wire harnesses.
4. Reliable structural connection and protection: the anti-interference flexible circuit board not only transmits signals but also serves as the flexible bridging member to connect the hard earhook and pod assemblies, and the package body can enclose and seal the joint between the hard housings, thus achieving structural integration and excellent waterproof performance.
5. Adaptation to sliding adjustment: at the apparatus level, the design of the flexible extension portion and the redundant bending section of the camera module cleverly solves the problem of line extension and contraction during sliding adjustment of a camera, avoids breakage of the main circuit board due to repeated stretching, and improves the mechanical lifespan of the product and the user experience.

Further, the anti-interference flexible circuit board in the present disclosure is configured as a flexible interconnection structure specifically designed to carry and connect at least one application specific integrated circuit. The application specific integrated circuit includes a control chip for image signal processing, audio signal processing, or wireless communication, which simultaneously generates high-speed digital signals, analog signals, and control signals during operation.

For the problems of electromagnetic coupling, common-ground noise, and signal integrity degradation that arise when the above application specific integrated circuit operates in a narrow and small space, in the present disclosure, the reference potential layer is formed in the flexible conductive laminated structure, the high-speed differential signal line group is arranged on the outer layer adjacent to the electromagnetic shielding film, the analog audio drive line group is physically isolated from the independent microphone ground line, and the shielding and protective structure formed by the entire package body is utilized, thereby providing a stable, low-interference signal interconnect environment for the application specific integrated circuit, and enabling reliable operation of the application specific integrated circuit in the limited space of a wearable device.

### BRIEF DESCRIPTION OF THE DRAWINGS

To more clearly illustrate the technical solutions in the embodiments of the present disclosure or in the prior art, the accompanying drawings that need to be used in the description of the embodiments or the prior art will be briefly introduced below. Apparently, the accompanying drawings in the description below merely illustrate some embodiments of the present disclosure. Those of ordinary skill in the art may also derive other accompanying drawings from these accompanying drawings without creative efforts.

In the figures:
FIG. 1 is a cross-sectional view of an anti-interference flexible circuit board of an audio apparatus with a camera function according to an embodiment of the present technical solution;
FIG. 2 is a top view of an anti-interference flexible circuit board of an audio apparatus with a camera function according to an embodiment of the present technical solution;
FIG. 3 is a flowchart of a method for fabricating an anti-interference flexible circuit board according to an embodiment of the present technical solution;
FIG. 4 is a cross-sectional view of a core layer according to an embodiment of the present technical solution;
FIG. 5 is a cross-sectional view in which a first conductive layer and a second conductive layer are formed on an upper surface and a lower surface of the core layer in FIG. 4 respectively;
FIG. 6 is a cross-sectional view in which an insulating medium is formed on the first conductive layer and the second conductive layer in FIG. 5;
FIG. 7 is a cross-sectional view in which an electromagnetic shielding film is formed on the first conductive layer and the second conductive layer in FIG. 5;
FIG. 8 is a schematic variation diagram in which a flexible conductive laminated structure covered with the electromagnetic shielding film in FIG. 7 is cut into an integrated flexible ribbon structure;
FIG. 9 is a schematic perspective view of an audio apparatus with a camera function according to an embodiment of the present technical solution;
FIG. 10 is a schematic exploded view of an audio apparatus with a camera function according to an embodiment of the present technical solution;
FIG. 11 is a schematic structural diagram in which a camera module of an audio apparatus with a camera function is slidably connected;
FIG. 12 is a schematic structural diagram in which an anti-interference flexible circuit board serves as a flexible bridging member connecting an earhook assembly and an pod assembly; and
FIG. 13 is a schematic structural diagram in which gaps between an anti-interference flexible circuit board and an earhook assembly and between the anti-interference flexible circuit board and an pod assembly are filled with elastic elements.

**Description of main component symbols**

| | |
|---|---|
| anti-interference flexible circuit board | 100 |
| flexible conductive laminated structure | 110 |
| mounting portion | 111 |
| connecting portion | 112 |
| first conductive layer | 120 |
| differential signal line group | 121 |
| analog audio drive line group | 122 |
| ground shielding line | 123 |
| second conductive layer | 130 |
| main clock line | 131 |
| core layer | 140 |
| microphone ground line | 141 |
| insulating medium | 150 |
| first insulating medium | 151 |
| second insulating medium | 152 |
| third insulating medium | 153 |
| electromagnetic shielding film | 160 |
| protective layer | 161 |
| metal layer | 162 |
| conductive adhesive layer | 163 |
| package body | 170 |
| audio apparatus with camera function | 200 |
| rear-hanging assembly | 210 |
| earhook assembly | 220 |
| proximal end | 220a |
| distal end | 220b |
| internal cavity | 221 |
| panel cover | 222 |
| pod assembly | 230 |
| hard housing | 231 |
| audio transducer | 232 |
| guide rail | 233 |
| microphone | 234 |
| camera module | 240 |
| main body portion | 241 |
| flexible extension portion | 242 |
| redundant bending section | 243 |
| connection terminal | 244 |
| housing assembly | 245 |
| main control circuit board | 250 |
| connector | 251 |
| rigid support strip | 260 |
| heat dissipation element | 270 |
| elastic element | 280 |

### DESCRIPTION OF THE EMBODIMENTS

The technical solutions in the embodiments of the present disclosure will be clearly and completely described below with reference to the accompanying drawings in the embodiments of the present disclosure. Apparently, the described embodiments are merely some rather than all of the embodiments of the present disclosure. All other embodiments obtained by those of ordinary skill in the art based on the embodiments in the present disclosure without creative efforts shall fall within the scope of protection of the present disclosure.

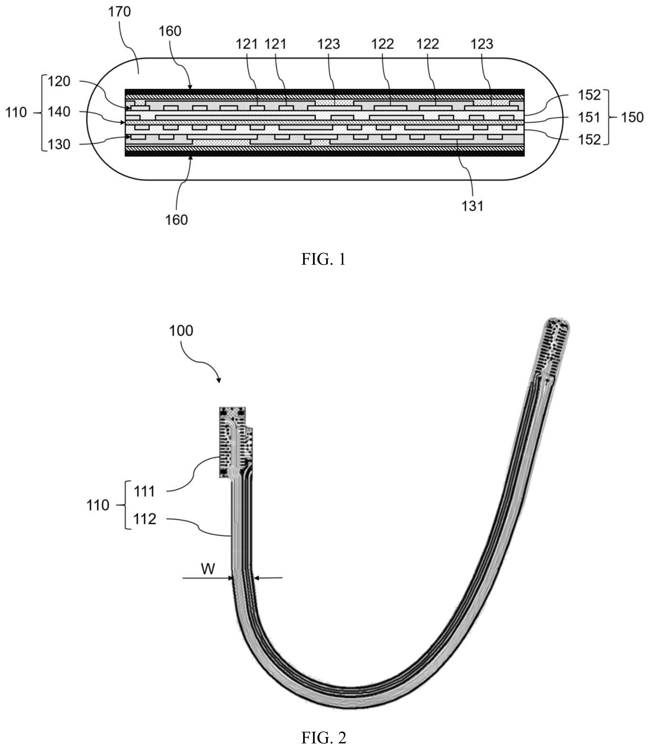

Reference is made to FIG. 1, which shows an anti-interference flexible circuit board 100 of an audio apparatus with a camera function according to an embodiment of the present technical solution. The anti-interference flexible circuit board 100 mainly includes a flexible conductive laminated structure 110, an electromagnetic shielding film 160, and a package body 170. As shown in FIG. 2, the flexible conductive laminated structure 110 is configured as an integrated flexible ribbon structure and divided into a mounting portion 111 and a connecting portion 112 in a length direction, where the connecting portion 112 has a width W of 2 mm to 12 mm. Specifically, the width W of the connecting portion 112 can be adjusted according to a structural shape, a wearing mode, and internal wiring requirements of the wearable audio apparatus to which it is applied. When the wearable audio apparatus is of an earhook structure, the connecting portion 112 usually needs to penetrate into a long and narrow curved space extending along an outer side of an auricle of a user, where the transverse dimension of the space is constrained by the contour of an ear and wearing comfort. Therefore, in a preferred embodiment, when used in the earhook structure, the width W of the connecting portion 112 is preferably controlled within 3.5 mm to fit a narrow channel inside an earhook assembly and avoid causing pressure or a foreign body sensation to the ear of the user. In another embodiment, when the wearable audio apparatus is of a head-mounted structure, the connecting portion 112 can be arranged along an outer side of the head or a headband structure, and an available transverse space thereof is increased compared with that of the earhook structure. Therefore, the width W of the connecting portion 112 can be appropriately increased to accommodate more conductive layers, shielding structures, or enhanced package bodies, but is generally still controlled within 12 mm to maintain the slimness of the overall appearance and ensure wearing comfort. It should be noted that, regardless of the specific value of the width W of the connecting portion 112 within the above range, the design objective is to minimize the transverse dimension on the premise of meeting the requirements for signal transmission, electromagnetic shielding, and structural strength, so as to reduce the burden on the user during prolonged wearing of the wearable apparatus. Therefore, in practical applications, the width W of the connecting portion 112 tends to be selected as a smaller value within the above range to achieve a balance between structural compactness and wearing comfort. In this embodiment, the flexible ribbon structure is slender to fit and penetrate into an internal space of a narrow cavity in the wearable audio apparatus. The mounting portion 111 is mainly configured to carry or be electrically connected to a functional module, which includes, for example, a camera module, an audio transducer interface, or other electronic components. The connecting portion 112 serves as a flexible bridging section extending outward from the mounting portion 111 to achieve electrical connection and signal transmission between different structural components. Specifically, the connecting portion 112 extends in the length direction, and the transverse dimension thereof is controlled to be not greater than 12 mm under the constraint of the wearing structure of the wearable apparatus, thereby enabling it to penetrate into various narrow internal channels and avoiding adverse effects on wearing comfort and external dimensions. Compared with a conventional wire harness structure formed by multiple round wires, the integrated flexible ribbon structure integrates multiple signal lines into a same flexible conductive laminate, which helps to significantly reduce wiring volume and improve overall structural consistency and reliability. In addition, since the mounting portion 111 and the connecting portion 112 are integrally formed in the same flexible conductive laminated structure 110, the problem of stress concentration at a connection node caused by soldering, bending, or stretching in a conventional wire is avoided, such that the flexible conductive laminated structure 110 can better adapt to repeated bending and displacement of the wearable apparatus during daily use, thereby improving the mechanical durability and service life of the entire apparatus.

Specifically, the flexible conductive laminated structure 110 includes: a first conductive layer 120 and a second conductive layer 130 that serve as outer signal layers, and a core layer 140 located between the first conductive layer 120 and the second conductive layer 130, where the first conductive layer 120, the core layer 140, and the second conductive layer 130 are separated by an insulating medium 150. The core layer is at least one conductive or composite conductive layer located in the middle of the flexible conductive laminated structure 100, mainly functioning to provide a reference potential, a signal return path, and mechanical support. In this embodiment, the first conductive layer 120 and the second conductive layer 130 are disposed on two opposite sides of the flexible conductive laminated structure 110 respectively to form a conductive layer structure located on an outermost side of the laminate, while the core layer 140 is disposed between the first conductive layer 120 and the second conductive layer 130 to provide internal structural support for the laminate. With the above multilayer structural configuration, the flexible conductive laminated structure 110 can still form a clearly layered laminated structure when its overall thickness is strictly controlled, thereby facilitating the integration of multiple conductive layers within the limited transverse dimension and meeting the requirements for layout in a narrow space.

In addition, the core layer 140 may be formed by a single conductive layer or may be a composite structure formed by a plurality of internal conductive layers separated by the insulating medium 150. For example, in this embodiment, the core layer 140 may be a double-sided copper-clad flexible substrate, i.e., a double-layer conductive structure separated by a layer of insulating medium; and in an alternative embodiment, the core layer 140 may also be a multilayer conductive structure formed by laminating at least two single-sided copper-clad flexible substrates according to the specific requirements for structural strength or the number of laminated layers. The insulating medium 150 is disposed between adjacent conductive layers to electrically isolate the conductive layers and provide mechanical support and buffering. By rationally selecting the thickness and material properties of the insulating medium 150, the reliability of interlayer insulation and the overall flexibility can be ensured without significantly increasing the total thickness of the laminate.

In this embodiment, the first conductive layer 120, the second conductive layer 130, and the core layer 140 may all be made of adhesive-free rolled copper. By omitting a conventional adhesive layer structure, the overall thickness of the flexible conductive laminated structure 110 can be effectively reduced, thereby reserving more sufficient stacking space for components in the mounting portion 111; moreover, compared with electrolytic copper, the rolled copper has better grain orientation consistency and ductility, thereby enabling the flexible conductive laminated structure 110 to exhibit superior flexibility and fatigue resistance during repeated bending or flexing. Therefore, the adhesive-free rolled copper laminated structure is especially suitable to be laid along a curved path in the width-constrained connecting portion 112 to meet the dynamic bending requirements on the connecting portion 112 during use.

The first conductive layer 120 and/or the second conductive layer 130 is provided with a differential signal line group 121 and a main clock line 131, where the differential signal line group 121 is used to transmit a digital video signal, and the main clock line 131 is used to synchronize clock frequencies of a master device and a slave device. In this embodiment, the differential signal line group 121 is arranged in the first conductive layer 120, while the main clock line 131 is arranged in the second conductive layer 130. By arranging the differential signal line group 121 and the main clock line 131 in the outermost layers of the flexible conductive laminated structure 110, the centralized layout of high-speed signal lines in the limited transverse space is facilitated, and a clear spatial positional relationship is provided for the subsequent electromagnetic shielding structure.

In this embodiment, a reference potential layer is formed in at least a part of the core layer 140 to provide a stable reference potential for a signal line on the first conductive layer 120 and/or the second conductive layer 130. The differential signal line group 121 and the core layer 140 are separated from each other by the insulating medium 150, and the insulating medium 150 has a preset interlayer thickness range, such that a relatively stable geometric spacing is formed between the differential signal line group 121 and the core layer 140. For example, the thickness of the insulating medium 150 may be between 15 µm and 60 µm; in an alternative embodiment, the thickness of the insulating medium 150 is about 25 µm; and in another alternative embodiment, the thickness of the insulating medium 150 is approximately 50 µm. The thickness of the insulating medium may be adjusted according to the dielectric constant of the material and the line width and spacing, and may be verified by means of impedance testing. By designing the material type and interlayer thickness of the insulating medium 150, expected distributed capacitance and distributed inductance parameters can be obtained for the differential signal line group 121 during transmission, thereby achieving the control over the characteristic impedance of a high-speed signal, maintaining the signal integrity of the digital video signal, and reducing the risks of reflection and distortion.

Further, the flexible conductive laminated structure 110 is further provided with an analog audio drive line group 122 for transmitting a drive current to an audio transducer. Compared with the high-speed digital video signal, the analog audio drive line group 122 carries a higher current during operation, so a relatively larger line width is adopted in the wiring design. In this embodiment, the line width of the analog audio drive line group 122 is not less than 0.2 mm, and ground shielding lines 123 with a line width of not less than 0.3 mm are arranged in parallel on both sides of the analog audio drive line group 122, thereby forming lateral electromagnetic isolation for the analog audio drive line group 122 in the same conductive layer to reduce crosstalk from adjacent lines. Generally speaking, a precise line refers to one with a width of less than 1 mil (approximately 0.25 mm). When transmitting a large dynamic audio signal, the direct current resistance (DCR) of the line will increase significantly, so a wider line needs to be designed to reduce the resistance, thereby minimizing audio distortion and preventing excessive temperature rise of the line caused by the heat effect of current from affecting the reliability in the narrow enclosed space. According to the principle of electromagnetic compatibility, the wider the ground line, the lower its inductance and impedance, and the more effectively it can conduct coupled interference noise into a main ground line network. Therefore, by arranging the ground shielding lines 123 with a relatively large line width in the same layer, a lateral coupling capacitor can be utilized to absorb an edge radiation field from an adjacent analog audio drive line group 122, thereby forming effective lateral electromagnetic isolation of the analog audio drive line group 122 in the same conductive layer. The above line width range can be matched with the overall thickness, number of layers, and spatial constraint of the flexible conductive laminated structure 110 on the premise of meeting the current-carrying and anti-interference requirements, thereby achieving a better balance between anti-interference performance and structural dimensions, and ensuring good engineering feasibility. In an alternative embodiment, when the core layer 140 is formed by the plurality of internal conductive layers, for example, the core layer 140 includes three or more internal conductive layers, the analog audio drive line group 122 can be allocated in different internal conductive layers to share the audio drive current and increase the overall current-carrying capacity. By distributing the analog audio drive line group 122 in different internal conductive layers, the current density on the single conductive layer can be reduced, and the reliability of an audio drive path can be improved without increasing the transverse dimension of the flexible conductive laminated structure 110.

In this embodiment, the main ground line network is configured in the flexible conductive laminated structure 110 to provide a common reference potential and return path for various circuits in the flexible conductive laminated structure 110, where the ground shielding lines 123 are in communication with the main ground line network to enhance the lateral electromagnetic isolation effect for the analog audio drive line group 122. The main ground line network may be formed by at least one internal conductive layer in the core layer 140, or may be formed by the ground lines disposed on the first conductive layer 120 and/or the second conductive layer 130 together with the reference potential layer in the core layer 140, thereby forming a continuous and low-impedance ground network in the laminated structure. Specifically, the main ground line network extends in the length direction of the flexible ribbon structure and is systematically connected to an external circuit via a terminal portion or a pad region to ensure consistency with a ground reference of the master device. The main ground line network is used to carry a return current of a high-speed digital signal, a return current of an audio drive signal, and a common return current generated by other functional modules, so a relatively large equivalent cross-sectional area is preferred in structural design to reduce the impedance of a ground path and minimize the fluctuation of a ground potential. In an embodiment, a continuous reference potential layer is formed in part or all of the core layer 140 and serves as a main component of the main ground line network, such that a stable reference plane can be obtained for the signal line located on the adjacent conductive layer, thereby facilitating the control of the signal return path and reducing the loop area. In another embodiment, the main ground line network may be in electrical communication with ground lines located in different conductive layers via conductive connection structures (e.g., vias, conductive adhesive connection points, or local conductive crimping structures); and preferably, the conductive connection structures can be disposed in regions with low bending requirements to reduce the fatigue risk caused by repeated flexing.

It should be noted that an electrically independent microphone ground line 141 is further disposed in the flexible conductive laminated structure 110 to reduce the impact of common-ground noise on audio signal quality. The microphone ground line 141 is continuously arranged along an independent conductive path throughout the length of the connecting portion 112 of the flexible ribbon structure, and along a path of the microphone ground line 141, it does not form an electrical connection with the analog audio drive line group 122 or the high-speed signal lines, nor is it electrically connected to the main ground line network, thereby maintaining physical isolation from the main ground line network in structure. In other words, the microphone ground line 141 maintains a preset spacing from the main ground line network along its path, and no conducting structure or conductive adhesive contact point is disposed in a non-pad region. Therefore, the microphone ground line 141 is equipotentially connected to the main ground line network only at the terminal portion and/or the pad position to form a single-point ground structure, thereby preventing the superposition of the audio drive current or the return current of the high-speed digital signal in the ground path of a microphone, and further reducing the impact of common-ground interference on the sound pickup quality of the microphone. In a preferred embodiment, a nano waterproof coating can be disposed on an outer surface of the flexible conductive laminated structure 110, where the nano waterproof coating is a thin film layer with a hydrophobic property, thereby further enhancing the protective capability of the flexible conductive laminated structure 110 in a humid, sweat, or water environment. Specifically, the nano waterproof coating can cover at least one exposed surface of the flexible conductive laminated structure 110, including but not limited to an outer surface of the first conductive layer 120, an outer surface of the second conductive layer 130, or outer surfaces of electronic components mounted on the first conductive layer 120 and the second conductive layer 130, thereby forming a continuous hydrophobic protective interface on an outer side of the flexible conductive laminated structure 110. By disposing the nano waterproof coating on the above surface, the adhesion of moisture or sweat on the surface of the flexible conductive laminated structure 110 can be reduced, thereby making it easier for liquids to form water droplets and roll off, and decreasing the likelihood of moisture remaining on the surface or penetrating into the interior. In this embodiment, the nano waterproof coating may be a functional coating with nanoscale thickness, and its material may be selected from fluoropolymers, siloxane-based materials, nano-modified resins, or other coating materials with hydrophobic or superhydrophobic properties. The nano waterproof coating may be formed by means of spraying, dip-coating, chemical vapor deposition, plasma treatment, or other film-forming processes applicable to the surface of the flexible circuit board, and maintains good adhesion to the outer surface of the flexible conductive laminated structure 110. Due to the relatively small thickness of the nano waterproof coating, while forming hydrophobic protection, it does not significantly affect the overall thickness, bending performance, or electrical characteristics of the flexible conductive laminated structure 110. Moreover, the provision of the nano waterproof coating can reduce the impact of humidity changes on the characteristic impedance and electromagnetic shielding continuity of the differential signal line group 121.

The electromagnetic shielding film 160 covers the outer surfaces of the first conductive layer 120 and the second conductive layer 130, such that in at least a part of the connecting portion 112, the core layer 140, the differential signal line group 121, and the main clock line 131 are together wrapped in a shielding cavity formed by the electromagnetic shielding film 160. By disposing the electromagnetic shielding film 160 on the outer side of the flexible conductive laminated structure 110, the connecting portion 112 structurally forms a relatively enclosed electromagnetic shielding space, thereby providing external shielding for the high-speed signal lines inside the flexible conductive laminated structure 110. In this embodiment, the electromagnetic shielding film 160 may be a metal thin film or a composite conductive film with electrical conductivity, and the electromagnetic shielding film 160 is continuously laid in the length direction of the flexible ribbon structure and covers the outer surfaces of the first conductive layer 120 and the second conductive layer 130. With the above configuration, a shielding cavity structure defined by the electromagnetic shielding film 160 on upper and lower sides is formed in the connecting portion 112 of the flexible conductive laminated structure 110, thereby achieving the confinement of an internal electromagnetic field under the condition of limited thickness. In this embodiment, the differential signal line group 121 specifically includes MCN, MCP, MDNO, and MDPO lines for transmitting MIPI interface signals. The differential signal line group 121 is disposed directly adjacent to the electromagnetic shielding film 160 in a lamination direction. Herein, the "adjacent" means that the differential signal line group 121 is separated from the electromagnetic shielding film 160 on the corresponding side by only one layer of insulating medium, and there are no other conductive layers or signal lines between the differential signal line group 121 and the electromagnetic shielding film 160. By configuring the above "adjacent" structure, the differential signal line group 121 is arranged close to the electromagnetic shielding film 160 to form a shortest electromagnetic coupling distance, such that a high-frequency electromagnetic field generated by the differential signal line group 121 during transmission of the high-speed digital signal can be absorbed or reflected by the electromagnetic shielding film 160 in a near-field region, thereby reducing the coupling of high-frequency energy to other conductive lines inside the flexible conductive laminated structure 110 and minimizing crosstalk and electromagnetic interference. Further, since the differential signal line group 121 itself adopts a paired differential structure, the signal currents in the two complementary lines flow in opposite directions, thereby enabling self-cancellation of radiation to a certain extent. However, under high-speed operating conditions, residual common-mode components or high-frequency edge radiation may still exist. By ensuring that the differential signal line group 121 is disposed adjacent to the electromagnetic shielding film 160 in the lamination direction, the above residual radiation components can be further suppressed, thereby structurally enhancing the electromagnetic compatibility of the high-speed digital signal. In this embodiment, the electromagnetic shielding film 160 may be grounded by being electrically connected to the main ground line network, thereby serving as the reference potential layer for electromagnetic shielding during operation; and in an alternative embodiment, a part of the electromagnetic shielding film 160 may also be connected to the main ground line network, so as to balance the shielding effect and the bending performance of the flexible conductive laminated structure 110. In this way, the electromagnetic shielding film 160 provides an effective electromagnetic isolation environment for the high-speed differential signal line group 121 without significantly increasing the structural thickness. Therefore, through the synergistic configuration of the electromagnetic shielding film 160 and the differential signal line group 121, this embodiment enables stable transmission of the high-speed digital video signal in the width-constrained flexible ribbon structure, and effectively reduces electromagnetic interference from the high-speed digital video signal to the analog audio drive line group 122, the microphone ground line 141, and other low-level signal lines during transmission. Accordingly, the present disclosure effectively reduces common-ground interference in hybrid transmission of high-speed digital signals and analog signals in a narrow and limited space through the design of layered wiring and shielding isolation, thus greatly improving the signal quality.

The package body 170 is mainly disposed at the connecting portion 112 to enclose the flexible conductive laminated structure 110 and form outer-layer protection, where the package body 170 is continuously disposed in the length direction of the connecting portion 112, such that the flexible conductive laminated structure 110 can be entirely enclosed, thereby preventing the connecting portion 112 from being directly exposed to the external environment. In this embodiment, the package body 170 is preferably made of a waterproof elastic material, such as silicone. By selecting the silicone with excellent elasticity and a soft touch as the material for the package body 170, the connecting portion 112 can fit the contour of the ear or head of the user during wearing, thereby improving wearing comfort and reducing pressure on the skin. Moreover, the silicone has excellent resilience. When bent or displaced, the connecting portion 112 can deform along with the flexible conductive laminated structure 110 without being prone to cracking or permanent deformation. In addition, the silicone itself has good water resistance and sweat resistance. By completely enclosing the flexible conductive laminated structure 110 with the package body 170 in a sealing manner, a continuous protective layer can be formed in the connecting portion 112, thereby preventing moisture, sweat, or dust from penetrating into the flexible conductive laminated structure 110 along the connecting portion 112 and improving the reliability of the apparatus in daily wearing and sports scenarios. In an embodiment, the package body 170 may be formed by means of injection molding, overmolding, or compression molding, thereby enabling tight fit between the package body 170 and the flexible conductive laminated structure 110. Specifically, the package body 170 not only serves a waterproof and protective function, but also provides flexible buffering to disperse mechanical stress generated in the connecting portion 112 due to bending, stretching, or external force, thereby reducing the risk of stress concentration at the terminal portion or the pad position of the flexible conductive laminated structure 110 and further enhancing the mechanical durability of the overall structure.

In an alternative embodiment, the package body 170 may also be made of other materials with elasticity and protective properties, such as thermoplastic elastomer (TPE) or thermoplastic polyurethane (TPU), to balance softness, wear resistance, and molding efficiency in different application scenarios. The selection of different materials as described above can achieve sealed enclosing and outer-layer protection of the flexible conductive laminated structure 110 without altering the basic functions of the package body 170. Through the configuration of the package body 170, the flexible conductive laminated structure 110 in the connecting portion 112 has multiple functions of waterproofing, protection, buffering, and comfortable fit at the same time.

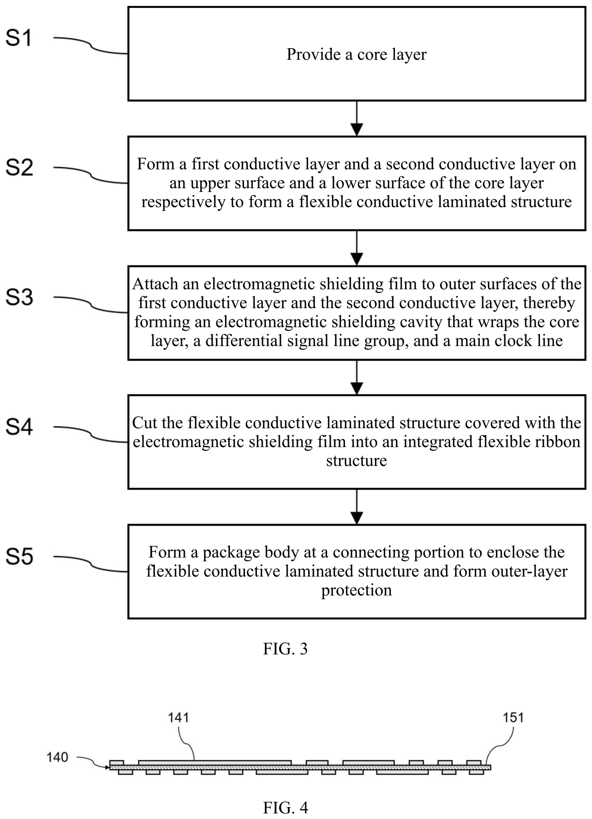

Reference is made to FIG. 3, which is a flowchart of a method for fabricating an anti-interference flexible circuit board of an audio apparatus with a camera function according to an embodiment of the present technical solution. The method mainly includes the following steps.

In a first step S1, referring to FIG. 4, a core layer 140 is provided, where a reference potential layer is formed in at least a part of the core layer 140. In an embodiment, the core layer 140 may include at least one conductive layer, which is continuously disposed in at least a part of the core layer 140 to form a reference potential layer. The reference potential layer is used to provide a stable reference potential and return path for high-speed signal lines and other signal lines in the subsequent laminated structure. In this embodiment, the core layer 140 adopts a double-sided copper-clad structure, that is, conductive layers are respectively formed on an upper surface and a lower surface of a first insulating medium 151, where the conductive layer on at least one side may be used as the reference potential layer. Specifically, the core layer 140 serves as an intermediate layer of the overall structure to provide mechanical support and electrical reference for the subsequently formed conductive layers, and the first insulating medium 151 is preferably a flexible substrate, such as polyimide (PI) or other insulating substrates applicable to the flexible circuit board, to balance heat resistance, mechanical strength, and bending performance. In an alternative embodiment, the core layer 140 may also be formed by a plurality of internal conductive layers. For example, a plurality of conductive layers separated by an insulating medium are disposed in a multilayer flexible substrate, and at least one internal conductive layer forms a reference potential layer in a predetermined region. In this way, the area, position, and continuity of the reference potential layer can be flexibly adjusted according to actual design requirements on the premise of ensuring controlled overall thickness. In a preferred embodiment, a reference potential layer can be continuously formed in a part of the core layer 140 to provide a stable reference plane for high-speed signal lines; and another part can be adjusted according to component layout or structural requirements, such as local windowing or partitioning, without affecting its basic function as a reference potential layer.

Through the above step S1, the provision of the core layer 140 is completed, enabling the core layer 140 to structurally have flexible supporting capability and electrically provide stable reference potential conditions for the subsequently formed conductive layers and signal lines, thereby laying a foundation for the formation of conductive structures and electromagnetic shielding structures in the subsequent steps.

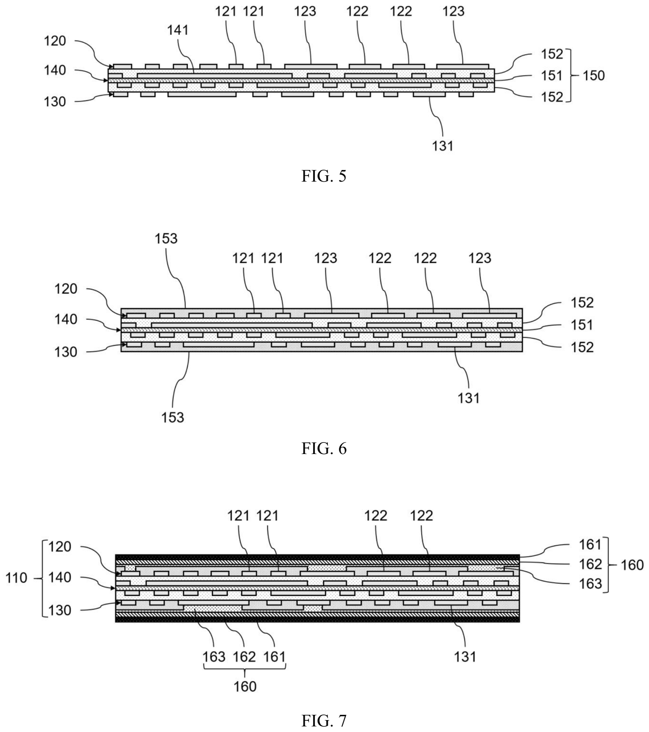

In a second step S2, referring to FIG. 5, a first conductive layer 120 and a second conductive layer 130 are formed on an upper surface and a lower surface of the core layer 140 respectively, where the first conductive layer 120 and the second conductive layer 130 are physically isolated from the core layer 140 by a second insulating medium 152 to form a flexible conductive laminated structure 110. The first conductive layer 120 and/or the second conductive layer 130 is patterned to form a differential signal line group 121 and a main clock line 131. In this embodiment, the first conductive layer 120 and the second conductive layer 130 are disposed on two opposite sides of the core layer 140 respectively. By disposing the second insulating medium 152 between the core layer 140 and the corresponding first conductive layer 120 and second conductive layer 130, the first conductive layer 120, the second conductive layer 130, and the substrate layer are electrically isolated from each other and stably laminated in structure, thereby forming a continuous flexible conductive laminated structure 110 as a whole. Specifically, the second insulating medium 152 may be formed of the same or compatible flexible substrate as the first insulating medium 151, to ensure consistent mechanical properties of the flexible conductive laminated structure 110 during subsequent bending or flexing. In this embodiment, the patterning of the first conductive layer 120 and/or the second conductive layer 130 may include photolithography, etching, or other line forming processes applicable to the flexible circuit board, such that signal lines with a predetermined routing can be formed in the first conductive layer 120 and/or the second conductive layer 130. Through the above patterning process, the differential signal line group 121 for transmitting a digital video signal and the main clock line 131 for providing timing synchronization are formed on the first conductive layer 120 and/or the second conductive layer 130. The above patterning process may be performed after the lamination is completed, or before the first conductive layer 120 and the second conductive layer 130 are attached to the core layer 140. The specific process sequence may be adjusted according to manufacturing conditions.

In this embodiment, the flexible conductive laminated structure 110 is further provided with an analog audio drive line group 122 for transmitting a drive current to an audio transducer. The analog audio drive line group 122 can be selected according to current-carrying requirements and overall laminate layout, and is formed in the first conductive layer 120, the second conductive layer 130, or the core layer 140 by patterning. In addition, an electrically independent microphone ground line 141 is further formed in the flexible conductive laminated structure 110. Preferably, the electrically independent microphone ground line 141 is formed in the core layer 140 and continuously arranged in a length direction of the flexible conductive laminated structure 110, making it maintain independent routing throughout the entire length of a connecting portion 112 of the flexible ribbon structure. During formation, the microphone ground line 141 is not electrically connected to the signal line in the first conductive layer 120 or the second conductive layer 130, thereby maintaining physical isolation from a main ground line network of the flexible conductive laminated structure 110. Therefore, the microphone ground line 141 is equipotentially connected to the main ground line network only at a predetermined pad position to form a single-point ground structure. In this way, a ground path of a microphone can be independently planned in the manufacturing stage, and the superposition with a return current of a high-speed signal or an audio drive current can be avoided during subsequent use, thereby reducing the impact of common-ground noise on the sound quality of the microphone.

By completing the above step S2, the flexible conductive laminated structure 110 with structurally and electrically defined lines is obtained, thereby laying a foundation for subsequent steps of attaching an electromagnetic shielding film, cutting a ribbon structure, and forming a package body.

Further, as shown in FIG. 6, after the patterning of the first conductive layer 120 and the second conductive layer 130 is completed, outer surfaces of the first conductive layer 120 and the second conductive layer 130 can be covered with a third insulating medium 153 to protect the signal lines located in the first conductive layer 120 and the second conductive layer 130. In this embodiment, the third insulating medium 153 is disposed on an outermost side of the flexible conductive laminated structure 110 to form temporary or permanent insulation coverage for exposed signal lines prior to subsequent process steps. By disposing the third insulating medium 153, the accidental scratching, contamination, or short-circuit risk of the first conductive layer 120 and the second conductive layer 130 during subsequent processing, handling, or lamination can be avoided, thereby improving the stability and yield of the manufacturing process. In an embodiment, the third insulating medium 153 may be a cover film, a protective film, or a solder mask, and its material may be selected from a polyimide film, a heat-resistant insulating coating, or other insulating materials applicable to the flexible circuit board. The third insulating medium 153 may be formed by means of attaching, coating, or laminating, and maintains excellent adhesion to the first conductive layer 120 and the second conductive layer 130, thereby providing effective protection without significantly increasing the overall thickness. In this embodiment, the third insulating medium 153 may continuously cover the first conductive layer 120 and the second conductive layer 130 to adapt to subsequent process of bending, cutting, or attaching of the electromagnetic shielding film 160; and the third insulating medium 153 may also be locally windowed according to component soldering or connection requirements, so as to expose a predetermined pad or connection region in the subsequent process.

By disposing the third insulating medium 153 on outer sides of the first conductive layer 120 and the second conductive layer 130, reliable electrical and mechanical protection can be provided for outer-layer signal lines in the manufacturing stage, and a relatively flat and stable surface condition can be provided for subsequent attaching of the electromagnetic shielding film, thereby facilitating the formation of a structurally complete flexible conductive laminated structure 110.

In a third step S3, referring to FIG. 7, an electromagnetic shielding film 160 is attached to outer surfaces of the first conductive layer 120 and the second conductive layer 130, thereby forming an electromagnetic shielding cavity that wraps the core layer 140, the differential signal line group 121, and the main clock line 131. The electromagnetic shielding film 160 is preferably a conductive silver foil with a multilayer composite structure, specifically including a conductive adhesive layer 163, a metal layer 162, and a protective layer 161 located on an outermost side. The conductive adhesive layer 163 is disposed on one side close to the flexible conductive laminated structure 110 and used to establish a stable electrical connection with the first conductive layer 120 or the second conductive layer 130 during attaching; the metal layer 162 is used to provide a primary electromagnetic shielding function; and the protective layer 161 is used to provide mechanical and environmental protection for the metal layer 162 against oxidation, abrasion, or damage from external force. In a preferred embodiment, the conductive adhesive layer 163 can be filled in an opening region of the third insulating medium 153 during attaching, such that the first conductive layer 120 and the second conductive layer 130 can form a reliable electrical communication path with the metal layer 162 via the conductive adhesive layer 163. In an alternative embodiment, the electromagnetic shielding film 160 may also be selected from other shielding materials with excellent conductivity and flexibility according to different product requirements, such as a conductive copper foil, a nickel-plated metal foil, or a composite conductive film, with the main purpose still being to establish a reliable electrical connection with the flexible conductive laminated structure 110 and to form a continuous shielding path. The third insulating medium 153 forms an opening at a predetermined grounding position to expose a grounding region of the first conductive layer 120 and/or the second conductive layer 130; and the conductive adhesive layer 163 fills the opening during attaching and contacts the grounding region, thereby enabling the electromagnetic shielding film 160 to form continuous conduction with the main ground line network.

With the above design, the electromagnetic shielding film 160 can form a continuous conductive enclosing structure with the flexible conductive laminated structure 110, thereby forming a closed or semi-closed electromagnetic shielding cavity. Therefore, the core layer 140, the differential signal line group 121, and the main clock line 131 can be enclosed as a whole inside the shielding cavity formed by the electromagnetic shielding film 160, thus significantly reducing the outward leakage of electromagnetic radiation generated by the high-speed digital signal during transmission. Further, since the differential signal line group 121 is disposed adjacent to the electromagnetic shielding film 160 in a lamination direction, an electromagnetic field generated by the high-frequency digital video signal during operation can be absorbed nearby by the electromagnetic shielding film 160 and reflected or attenuated by the metal layer 162, thereby reducing electromagnetic interference to analog audio lines and other sensitive signal lines inside a laminate. Moreover, the core layer 140 serves as a reference potential layer and forms a stable electromagnetic environment together with the electromagnetic shielding film 160, which is beneficial to further improving the signal integrity of high-speed signal transmission.

Through the above step S3, the structurally complete and electrically continuous electromagnetic shielding cavity can be formed in the specific region without significantly increasing the overall thickness of the flexible conductive laminated structure 110, thereby laying a foundation for the subsequent stable hybrid transmission of high-speed digital video signals and analog audio signals in a narrow space.

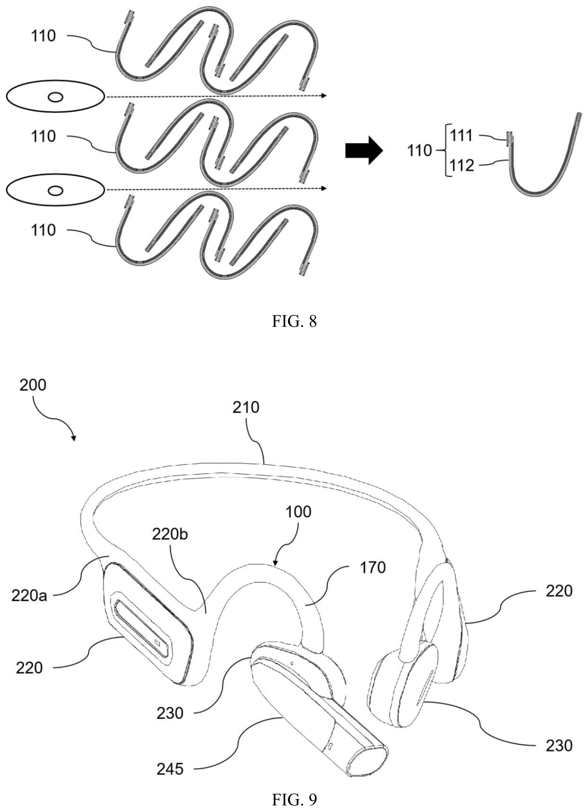

In a fourth step S4, referring to FIG. 8, the flexible conductive laminated structure 110 covered with the electromagnetic shielding film 160 is cut into an integrated flexible ribbon structure and divided into a mounting portion 111 and a connecting portion 112 in a length direction, where the connecting portion 112 has a width W of 2 mm to 12 mm. In a preferred embodiment, the width W of the connecting portion 112 may be controlled to be not greater than 3.5 mm. Specifically, the cutting step is performed after the attaching of the electromagnetic shielding film 160 is completed, such that the cut flexible ribbon structure retains the complete flexible conductive laminated structure 110 and electromagnetic shielding film 160 in both the mounting portion 111 and the connecting portion 112, thereby preventing damage to the continuity of electromagnetic shielding or the integrity of an interlayer structure due to improper cutting during subsequent use. The flexible conductive laminated structure 110 may be in the form of connected plates arranged in a matrix before cutting. Through a precision cutting process such as laser cutting, punching, or computer numerical control die cutting, the flexible conductive laminated structure 110 is cut into an integrated flexible ribbon structure extending in the length direction. The contour shape of the flexible ribbon structure can be predesigned according to the overall structure of the product, such that the cut flexible ribbon structure forms a continuously extending shape in a longitudinal direction. In this embodiment, at least the mounting portion 111 and the connecting portion 112 with different functions are defined in the length direction of the flexible ribbon structure. The mounting portion 111 has a larger local width than the connecting portion 112 and is used to accommodate or carry electronic components, pad regions, or structures electrically connected to a camera module 240, a circuit board, and other components; while the connecting portion 112 serves as a channel for the outward extension and electrical connection of the mounting portion 111, and is mainly used to achieve flexible bridging and signal transmission in the narrow space. In a preferred embodiment, the connecting portion 112 is cut into a narrow structure with a width W of not greater than 3.5 mm, to fit the internal space of an earhook assembly, a turning cavity, or other narrow channels in the audio apparatus. By controlling the width of the connecting portion 112 within the above range, the flexible ribbon structure can be laid and bent under the condition of a small curvature radius without sacrificing the multilayer laminated structure and shielding structure, thereby balancing the wiring density and wearing comfort.

Further, the mounting portion 111 and the connecting portion 112 are of an integrally formed structure, with no independent splicing or welding interface therebetween, thereby avoiding the problem of mechanical stress concentration or electrical discontinuity caused by interfacial transition. Through integral cutting and forming, a smooth transition is formed between the mounting portion 111 and the connecting portion 112 of the flexible ribbon structure, which helps to maintain structural reliability during subsequent assembly or dynamic bending. In an alternative embodiment, the specific length ratio, outer contour, or local width of the connecting portion 112 and the mounting portion 111 can be adjusted according to different product structure requirements, as long as the connecting portion 112 maintains a width of not greater than 3.5 mm and is capable of achieving flexible connection and signal transmission functions.

Through the above fourth step S4, the flexible conductive laminated structure 110 is formally transformed from a semi-finished product in the form of connected plates into an integrated flexible ribbon structure with distinct functional zones, thereby laying a foundation for subsequent formation of a package body and assembly with an internal structure of the audio apparatus.

In a fifth step S5, referring to FIG. 1 again, a package body 170 is formed at the connecting portion 112 to enclose the flexible conductive laminated structure 110 and form outer-layer protection. In this embodiment, the package body 170 is mainly formed in the connecting portion 112 of the flexible ribbon structure, while the mounting portion 111 is at least partially exposed or provided with only a local protective structure, so as to facilitate subsequent electrical connection and assembly with a main control circuit board, the camera module, or other electronic components. By limiting the package body 170 to the connecting portion 112, sufficient protection can be provided in a bending region, while avoiding unnecessary restrictions on the soldering, assembly, and dimensional layout of the mounting portion 111. In a preferred embodiment, the package body 170 is made of a waterproof elastic material, preferably silicone, and formed by means of injection molding. Specifically, after the fourth step S4 is completed, the cut and formed flexible ribbon structure can be placed in a preset mold cavity such that the connecting portion 112 is located in an injection molding region of the mold cavity, while the mounting portion 111 extends out of the mold cavity via a positioning structure. Subsequently, liquid or semi-fluid silicone is injected into the mold cavity by means of an injection molding process such that the liquid or semi-fluid silicone encloses an outer surface of the connecting portion 112, and a continuous and dense package body 170 is formed after curing. In this embodiment, the silicone has good elastic resilience and a soft touch after curing, such that the package body 170 provides effective mechanical buffering and stress dispersion for the flexible conductive laminated structure 110 without significantly increasing the overall rigidity of the connecting portion 112. When the connecting portion 112 undergoes repeated bending, twisting, or stretching during use, the package body 170 can absorb and disperse the external force, thereby reducing the risk of fatigue damage to the internal conductive layers and the insulating media.

Further, the package body 170 is continuously attached to the outer surfaces of the electromagnetic shielding film 160, the third insulating medium 153, and the flexible conductive laminated structure 110 during formation, thereby forming a continuous sealed structure in the connecting portion 112. Specifically, the package body 170 is continuously formed in the length direction of the connecting portion 112, and an integrated package transition section is formed in a transition region between the connecting portion 112 and the mounting portion 111 to avoid forming a leakage channel at a boundary. In an embodiment, the package body 170 forms a sealing edge structure at at least one end of the connecting portion 112, and the sealing edge structure extends around an outer periphery of the flexible conductive laminated structure 110 to cover and encapsulate the edges of the electromagnetic shielding film 160 and the third insulating medium 153, thereby reducing the risk of capillary infiltration of liquid along an interlayer interface. In another embodiment, the package body 170 can form a continuous sealing lip or sealing annular band at an assembly position with an external housing or the earhook assembly 220, such that after assembly, the package body 170 forms a surface-contact or line-contact sealing fit with an inner wall of the housing, thereby blocking a path for sweat or moisture to enter the interior of the connecting portion 112 along an assembly gap. Thus, the package body 170 can achieve a reliable waterproof sealing effect in wearing and sports scenarios. Under reasonable packaging continuity and assembly sealing conditions, the sealing design of the package body 170 helps to improve waterproof performance and can be used to meet waterproof requirements such as IPX7 or IPX8 rating. In an alternative embodiment, in addition to the silicone, the package body 170 may also be made of other polymer materials with elasticity, waterproofness, and biocompatibility, such as thermoplastic elastomer (TPE), liquid silicone rubber (LSR), or polyurethane elastomer, as long as it can stably enclose the connecting portion 112 via the molding process and provide corresponding protection and buffering.

Through the above step S5, without altering the internal lamination relationship and electrical structure of the flexible conductive laminated structure 110, an integrated package body 170 with waterproof, buffering, and fixing functions can be formed on the connecting portion 112, such that the anti-interference flexible circuit board 100 serves not only as a signal transmission carrier, but also as a flexible bridging member between different hard structures inside the audio apparatus, thereby significantly improving the reliability and service life of the entire apparatus in complex usage environments.

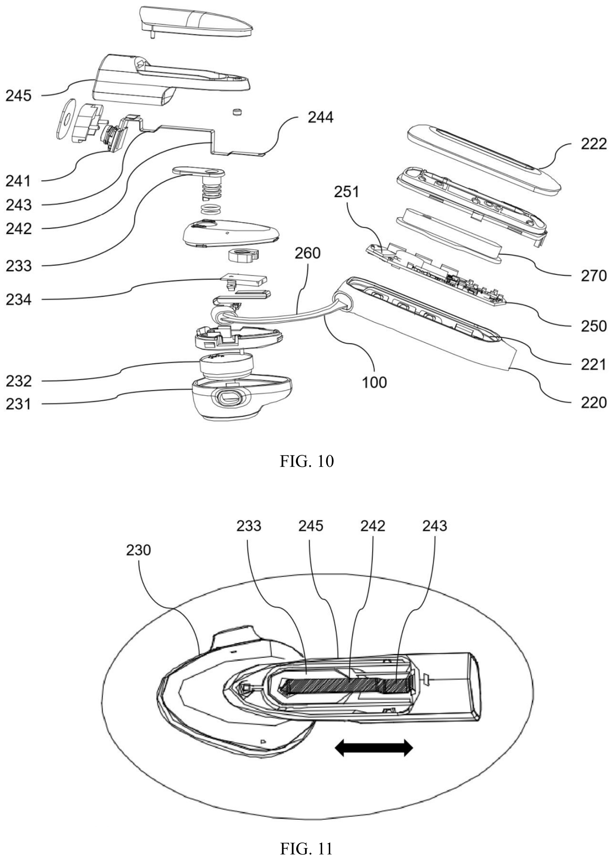

Reference is made to FIG. 9 and FIG. 10, which are a schematic perspective view and a schematic exploded view of an audio apparatus 200 with a camera function according to an embodiment of the present technical solution. The audio apparatus 200 with a camera function mainly includes: a rear-hanging assembly 210, earhook assemblies 220, at least one pod assembly 230, a camera module 240, and a main control circuit board 250.

The rear-hanging assembly 210 is configured to encircle a rear side of the head of a user so as to span an occipital region of the user in a worn state, thereby providing overall support and stable positioning for the audio apparatus 200 with a camera function. In this embodiment, the rear-hanging assembly 210 may adopt a structure with certain elastic resilience, such that the rear-hanging assembly 210 is capable of opening moderately when worn and rebounding after release to fit the head sizes of different users. In an embodiment, the rear-hanging assembly 210 may include an internal support member and an outer rubber-coated layer, where the internal support member may be made of elastic metal, engineering plastic, or a composite material and configured to provide basic structural strength; and the outer rubber-coated layer may be formed of silicone or other elastic materials to enhance wearing comfort and avoid a hard pressure sensation from direct contact with the skin. In an alternative embodiment, the rear-hanging assembly 210 may also adopt an integrally formed elastic structure without a separate internal support member.

The earhook assemblies 220 are connected to both ends of the rear-hanging assembly 210 respectively. That is, in this embodiment, at least two earhook assemblies 220 are included, where each earhook assembly 220 has a proximal end 220a connected to the rear-hanging assembly 210 and a distal end 220b extending above an auricle of the user and pointing to a facial region of the user. The earhook assembly 220 is arranged along an outer side of the auricle of the user in the worn state to provide structural support and positioning reference for the audio apparatus 200 with a camera function and stably position a front functional assembly near an ear of the user. It should be noted that, in this embodiment, the earhook assembly 220 itself is not configured to directly implement an audio output function and mainly functions as a structural carrier and an internal wiring channel, while the audio output and camera functions are jointly implemented by the pod assembly 230 connected to the earhook assembly 220 and the anti-interference flexible circuit board 100. Specifically, as shown in FIG. 10, the earhook assembly 220 can form an elongated internal cavity 221, where the internal cavity 221 is formed in an extension direction of the earhook assembly 220 to accommodate at least a part of the main control circuit board 250 and the anti-interference flexible circuit board 100. By forming the internal cavity 221 inside the earhook assembly 220, a connecting portion 112 of the anti-interference flexible circuit board 100 can penetrate into the earhook assembly 220, thereby preventing exposed wires in appearance and reducing the likelihood of friction between the wires and the skin or external objects during wearing. In this embodiment, the main control circuit board 250 is disposed in the internal cavity 221 of one of the earhook assemblies 220 and arranged close to one side of the rear-hanging assembly 210 to be structurally close to a rear support region, thereby facilitating overall center-of-gravity distribution and wearing stability. The main control circuit board 250 is mainly configured to control the overall functions of the audio apparatus 200 with a camera function, and may integrate thereon circuit modules for video signal processing, audio signal processing, wireless communication, and power management. In addition, a connector 251 is disposed on the main control circuit board 250, where the connector 251 is configured to be in plug-in connection with the connecting portion 112 of the anti-interference flexible circuit board 100. By disposing the connector 251, the anti-interference flexible circuit board 100 can establish an electrical connection with the main control circuit board 250 in a plug-in manner during the assembly stage, thereby reducing the thermal stress impact of the soldering process on the flexible circuit board and improving assembly efficiency and reliability. In an embodiment, a guiding structure or a limiting structure may be locally formed in a local region of the internal cavity 221 of the earhook assembly 220 to position the connecting portion 112 of the anti-interference flexible circuit board 100, such that the connecting portion 112 of the anti-interference flexible circuit board 100 maintains a predetermined routing inside the earhook assembly 220, thereby avoiding compression, torsion, or stress concentration caused by relative displacement during wearing or use. With the above structural configuration, one of the earhook assemblies 220 may serve as an integrated carrier for the anti-interference flexible circuit board 100 and the main control circuit board 250, while the earhook assembly 220 located on the other side may be configured to accommodate a power-related component (such as a battery or its protection circuit), thereby facilitating balanced weight distribution between left and right sides. The specific configuration may be adjusted according to product requirements, thereby achieving functional division between the left and right earhook assemblies 220 and enhancing the flexibility of the overall structural layout and wearing stability.

In a preferred embodiment, a heat dissipation element 270 may further be disposed on the main control circuit board 250 to effectively conduct away heat generated by the main control circuit board 250 during video processing, audio processing, or wireless communication. Specifically, the heat dissipation element 270 may be closely attached to the main control circuit board 250 via a thermally conductive medium, where the thermally conductive medium may be a thermal adhesive, a thermal pad, or any other elastic material with thermal conductivity, thereby forming a stable heat conduction path between the main control circuit board 250 and the heat dissipation element 270. In this embodiment, the heat dissipation element 270 may extend in a thickness direction of the earhook assembly 220 and penetrate through a panel cover 222 of the earhook assembly 220, such that at least a part of the heat dissipation element 270 is directly exposed to the external environment. With the above structural configuration, the heat generated by the main control circuit board 250 during operation can be conducted via the thermally conductive medium to the heat dissipation element 270, and further dissipated from the heat dissipation element 270 into the outside air, thereby reducing the operating temperature of the main control circuit board 250. In an alternative embodiment, the heat dissipation element 270 may be a metal heat sink, a metal heat dissipation block, or a structural member with a heat dissipation function, and may form an integrated structure with the panel cover 222. In another alternative embodiment, the heat dissipation element 270 may only partially penetrate through the panel cover 222 or may be disposed in a region close to an outer surface of the earhook assembly 220, so as to achieve a heat dissipation effect while maintaining the integrity of the appearance and wearing comfort. By introducing the above heat dissipation element 270 into the earhook assembly 220, the heat dissipation capability of the main control circuit board 250 can be effectively improved without significantly increasing the volume or weight of the apparatus, thereby helping to ensure the performance stability and reliability of the audio apparatus 200 with a camera function during prolonged operation or in a high-load state. In addition, the heat dissipation element 270 may further integrate a temperature sensor, where the temperature sensor is electrically connected to the main control circuit board 250 and configured to monitor a temperature change of the main control circuit board 250 in real time during operation. Specifically, the temperature sensor may be disposed on one side of the heat dissipation element 270 close to the main control circuit board 250, or disposed on the heat conduction path between the heat dissipation element 270 and the main control circuit board 250, such that the temperature sensor can accurately sense a heat variation generated by the main control circuit board 250 and conducted to the heat dissipation element 270, thereby reflecting an actual operating temperature of the main control circuit board 250. In this embodiment, the temperature sensor may be a thermistor, a digital temperature sensor, or any other temperature detection element applicable to an electronic apparatus, and establishes an electrical connection with the main control circuit board 250 via a wire or a pad, thereby enabling the main control circuit board 250 to obtain a corresponding temperature signal. In an embodiment, the main control circuit board 250 may adjust operating parameters related to video processing, audio processing, or wireless communication based on temperature information output by the temperature sensor, or execute control measures such as frequency reduction, power limiting, or protective shutdown when the temperature exceeds a preset threshold. By integrating the temperature sensor into the heat dissipation element 270 and forming a closed-loop monitoring and control relationship with the main control circuit board 250, collaborative heat management can be achieved at both the structural and circuit control levels, thereby preventing performance degradation, signal quality deterioration, or reliability reduction of the main control circuit board 250 due to overheating. Thus, the audio apparatus 200 with a camera function can still maintain stable signal transmission and overall functional performance during prolonged operation, high-load operation, or under high ambient temperature conditions.

At least one pod assembly 230 is physically connected to the distal end 220b of the earhook assembly 220 via the anti-interference flexible circuit board 100 and arranged close to the ear of the user, and serves as a functional integration end of the audio apparatus 200 with a camera function. The pod assembly 230 has a hard housing 231, where the hard housing 231 may be made of plastic, metal, or a composite material, and is configured to provide structural support and positioning protection for internal functional components. An accommodating space is formed inside the hard housing 231 to accommodate an audio transducer 232, a microphone, and at least one electronic component related to the camera function. In this embodiment, the pod assembly 230 is in electrical connection and physical structural bridging connection with the earhook assembly 220 via the anti-interference flexible circuit board 100. Specifically, a mounting portion 111 of the anti-interference flexible circuit board 100 extends into the hard housing 231 in an assembly direction of the pod assembly 230 and is electrically connected to the audio transducer 232, the microphone, and/or other electronic components; while the connecting portion 112 of the anti-interference flexible circuit board 100 is threaded through the earhook assembly 220 and is configured to establish a flexible electrical connection channel between the pod assembly 230 and the main control circuit board 250. With the above structural configuration, the anti-interference flexible circuit board 100 not only serves as a transmission carrier for electrical signals, but also functions as a flexible bridging member connecting the earhook assembly 220 and the pod assembly 230, such that the pod assembly 230 to undergo slight displacement or angular change relative to the earhook assembly 220 during wearing or use without imposing excessive mechanical stress on internal conductive lines, thereby improving the reliability of the overall structure. In this embodiment, at least one microphone 234 is disposed in the pod assembly 230, where the microphone 234 is configured to capture user voice or ambient sound. The microphone 234 directly forms a ground network with the connector 251 via an independent microphone ground line 141 in the anti-interference flexible circuit board 100 to electrically establish a single-point grounding relationship with a main ground line network in the flexible conductive laminated structure 110, thereby isolating common-ground interference caused by audio drive currents or return of high-speed digital signals, and improving the signal-to-noise ratio and stability of sound pickup of the microphone. In this embodiment, the audio transducer 232 may be a bone conduction transducer for transmitting an audio signal to the skull or ear bone structure of the user via mechanical vibration through the pod assembly 230, thereby achieving audio output in an open-ear state. In an alternative embodiment, the audio transducer 232 may also be an air conduction speaker for radiating sound to an ear canal of the user via air vibration, so as to meet different user requirements for sound quality, wearing modes, or usage scenarios. It should be noted that, regardless of whether the audio transducer 232 adopts bone conduction or air conduction, it is electrically connected to the main control circuit board 250 via the anti-interference flexible circuit board 100, and can share an anti-interference structure, an independent grounding design, and a packaging protective structure provided by the anti-interference flexible circuit board 100, thereby achieving universality and scalability in structural design.

Furthermore, at least one application specific integrated circuit is disposed on the main control circuit board 250 to perform video signal processing, audio signal processing, and system control functions. The application specific integrated circuit is electrically connected to the camera module 240, the audio transducer 232, and the microphone 234 via the anti-interference flexible circuit board 100. Since the application specific integrated circuit involves both high-speed digital signals and analog signals during operation, it has high requirements for impedance continuity, electromagnetic shielding effect, and grounding stability of external interconnection structures. Therefore, in the present disclosure, the anti-interference flexible circuit board 100 is designed as a multilayer laminated flexible printed circuit, and a reference potential layer is formed in a core layer 140 thereof, such that a stable signal reference plane can be obtained for the application specific integrated circuit in different operating modes, thereby effectively reducing the problem of signal reflection, crosstalk, or noise amplification caused by improper interconnection structures.

The camera module 240 is slidably connected to an outer side of the pod assembly 230 and configured to acquire a video signal from a first-person view. In this embodiment, the camera module 240 is disposed at a position of the pod assembly 230 close to one side of the face of the user, such that the camera module 240 can obtain a shooting angle substantially consistent with a line-of-sight direction of the user in the worn state, thereby achieving first-person view (FPV) video capture. In this embodiment, the camera module 240 includes a main body portion 241 and a flexible extension portion 242 integrally extending from the main body portion 241. An image sensor and a corresponding optical assembly are integrated in the main body portion 241 for image acquisition, where the flexible extension portion 242 is configured to establish an electrical connection between the camera module 240 and the anti-interference flexible circuit board 100, and to provide a flexible transition in terms of structure. Specifically, a redundant bending section 243 is provided in the flexible extension portion 242. In a natural state, the redundant bending section 243 is in an S-shaped, U-shaped, or wave-shaped structure, or the redundant bending section 243 may be designed as a serpentine structure capable of being repeatedly bent. The flexible extension portion 242 and the redundant bending section 243 may be integrally formed using a same flexible circuit board material system, not spliced from different materials, and both the flexible extension portion 242 and the redundant bending section 243 include a flexible insulating layer with polyimide (PI) as a base material, and a rolled copper foil conductive layer disposed on a surface of the base material. The redundant bending section 243 extends in a length direction of the flexible extension portion 242, and the total length of the redundant bending section 243 is preferably between 10 mm and 30 mm, such as 12 mm or 15 mm, so as to provide a sufficient extension and contraction margin in a limited structural space. A single bending section in the redundant bending section 243 may have a preset minimum bending radius, which is preferably not less than 0.3 mm, and more preferably not less than 0.5 mm, so as to ensure that the flexible extension portion 242 does not suffer from fatigue fracture in the conductive lines or damage to the insulating layer during repeated bending or sliding. In an embodiment, the serpentine structure may be formed by a plurality of continuous bending units, with a pitch between adjacent bending units preferably ranging from 0.8 mm to 2.5 mm, in order to balance deformability and structural stability. Through the above dimensional and structural design, when the camera module 240 slides in a front-rear direction, the redundant bending section 243 can absorb the relative displacement generated by the camera module 240 through changes in a bending angle or expansion and compression of a bending amplitude, thereby avoiding direct transmission of mechanical stress to a soldering position or a connection terminal between the flexible extension portion 242 and the anti-interference flexible circuit board 100. Therefore, the redundant bending section 243 not only provides a necessary extension and contraction buffering function structurally, but also significantly enhances the connection reliability and service life of the camera module 240 during repeated adjustment or long-term use. In fact, since the overall width of the anti-interference flexible circuit board 100 needs to be controlled to be not greater than 12 mm, especially for narrow-width applications not exceeding 3.5 mm, it is not suitable for more complex bending designs to adapt to a narrow and limited space; whereas the layout space for the camera module 240 is relatively open, making it suitable for a redundant bending design. By disposing the redundant bending section 243, the flexible extension portion 242 has a deformable margin in the length direction. When the camera module 240 slides in the front-rear direction relative to the pod assembly 230, the flexible extension portion 242 can absorb the displacement change through expansion or compression of the redundant bending section 243, thereby avoiding direct transmission of tensile or compressive stress generated by sliding to the anti-interference flexible circuit board 100 or the soldering/connection position.

In an embodiment, the redundant bending section 243 may undergo a bending fatigue test for reliability verification. For example, with the redundant bending section 243 as a bending center, a reciprocating tensile bending test may be performed at a bending radius of 1.0 mm and a bending angle of +90°, and the redundant bending section may withstand no fewer than 10,000 tensile bending cycles without conduction failure or significant resistance abnormality, thereby meeting the reliability requirements of a wearable device in daily wearing and repeated adjustment scenarios. It should be noted that the number of tensile bending cycles and the testing conditions described above are provided as an exemplary embodiment, and the bending radius, bending angle, or number of test cycles may be adjusted according to product design requirements, material specifications, and usage scenarios in practice. Through the above structural design, the camera module 240 achieves a sliding adjustment function while maintaining a flexible electrical connection path, thereby significantly reducing the risk of fatigue fracture in the conductive lines caused by repeated sliding or adjustment, and improving the reliability of the camera function during long-term use.

In addition, the camera module 240 integrates an image stabilization module disposed in or on the main body portion 241 and configured to maintain the stability of image acquisition when the camera module 240 moves with the head of the user. In other words, it can be configured to compensate for shake during image acquisition when the camera module 240 moves, walks, or rotates with the head of the user. In a preferred embodiment, the image stabilization module may be a gyroscope, where the gyroscope is configured to detect in real time an angular velocity or an angular displacement change of the camera module 240 in at least one direction, and to output corresponding motion data to an image processing unit of the camera module 240 or the main control circuit board 250 for image stabilization compensation calculations. Specifically, the gyroscope may be disposed in the main body portion 241 of the camera module 240, or mounted on a circuit board of the main body portion 241, and is located approximately in the same horizontal plane as a lens assembly of the camera module 240. By spatially aligning the gyroscope with the lens assembly, angular motion information detected by the gyroscope can more accurately reflect an actual attitude change of a lens, thereby improving the accuracy and response consistency of an image stabilization compensation algorithm. In an embodiment, the gyroscope may work in cooperation with the image sensor to perform electronic image stabilization (EIS) processing on an acquired image signal based on the detected head motion data, for example, by cropping, shifting, or resampling image frames to counteract image shake caused by slight head movement or walking. In another embodiment, the motion data output by the gyroscope may also be transmitted to the main control circuit board 250, and then the main control circuit board 250 performs image stabilization calculations in a unified manner or integrates the motion data with a video encoding process. By integrating the image stabilization module into the camera module 240, the audio apparatus 200 with a camera function can continuously obtain relatively stable first-person view video images during wearing, movement, or daily activities of the user, making it especially applicable to outdoor recording, sports recording, or long-term wearing application scenarios. Since the image stabilization module is integrated with the camera module 240, an additional mechanical image stabilization structure may not be required, thus effectively improving image acquisition quality and user experience without significantly increasing the size or weight of the camera module 240.

In this embodiment, as shown in FIG. 10, a connection terminal 244 is soldered to a tail end of the flexible extension portion 242, where the connection terminal 244 may be soldered and fixed to the mounting portion 111 of the anti-interference flexible circuit board 100 by surface mount technology, or the connection terminal 244 may be plugged into a corresponding interface of the mounting portion 111 of the anti-interference flexible circuit board 100, thereby achieving both electrical conduction and mechanical fixation between the camera module 240 and the anti-interference flexible circuit board 100. By adopting the surface mount technology for connection, the connection reliability can be ensured while reducing the height dimension of a soldering region, which is further conducive to miniaturization and compact design of the overall structure. Preferably, a guide rail 233 or a sliding groove extending in a front-rear direction is formed on the outer side of the pod assembly 230, and the camera module 240 is slidably connected by cooperating with the guide rail 233 or the sliding groove. Specifically, as shown in FIG. 11, the camera module 240 further includes a housing assembly 245, where the housing assembly 245 not only accommodates the main body portion 241 and the flexible extension portion 242, but also has a limiting structure matching the guide rail 233, which is configured to define a sliding path of the camera module 240, such that the camera module 240 can only move in a predetermined direction, thereby ensuring the stability and controllability of shooting angle adjustment. The user can adjust the position of the camera module 240 in the front-rear direction according to wearing positions or usage requirements, so as to change a horizontal field of view of a captured image. By configuring the camera module 240 as a slidable structure, and in combination with the collaborative design of the flexible extension portion 242 and the redundant bending section 243, the audio apparatus 200 with a camera function achieves adjustable shooting angle and high reliability of electrical connection structures without increasing overall size or compromising wearing stability, making it particularly applicable to sports, outdoor recording, and other application scenarios requiring high first-person view stability.

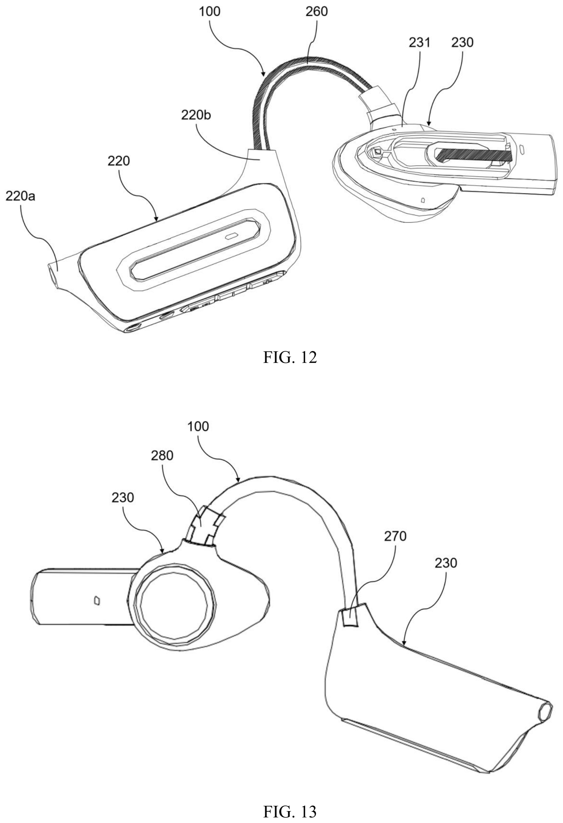

Specifically, as shown in FIG. 12, the anti-interference flexible circuit board 100 serves as a flexible bridging member connecting the earhook assembly 220 and the pod assembly 230, and continuously extends along a structural connection path of the apparatus. The connecting portion 112 of the anti-interference flexible circuit board 100 extends through the internal cavity 221 of the earhook assembly 220, and establishes an electrical connection with the main control circuit board 250 disposed in the earhook assembly 220 in a plug-in manner; and the mounting portion 111 of the anti-interference flexible circuit board 100 extends forward into the hard housing 231 of the pod assembly 230, and forms an electrical connection with the camera module 240 and/or the audio transducer 232. With the above structural configuration, the anti-interference flexible circuit board 100 serves both electrical interconnection and structural transition functions in the structure of the entire apparatus, such that no additional independent wire harness or multi-section connector is required between the earhook assembly 220 and the pod assembly 230, thereby forming a continuous integrated connection path structurally. In this embodiment, a package body 170 of the anti-interference flexible circuit board 100 is disposed in the connecting portion 112 and extends to enclose a connection region between the distal end 220b of the earhook assembly 220 and the hard housing 231 of the pod assembly 230, thereby forming a continuous outer-layer protective structure in this region. Through the enclosing and sealing by the package body 170, the anti-interference flexible circuit board 100 is not directly exposed to the external environment at a transition position where it penetrates through the earhook assembly 220 and enters the pod assembly 230, which helps to prevent moisture, sweat, or dust from entering the interior of the apparatus along the connection path. The anti-interference flexible circuit board 100 serves as a primary hybrid signal transmission channel inside the entire apparatus to simultaneously transmit the video signal from the camera module 240 and the audio signal from the audio transducer 232. By collectively integrating the high-speed digital video signal and the analog audio signal into the same flexible conductive laminated structure 110, and in combination with the aforementioned differential wiring, electromagnetic shielding, and independent grounding design, stable transmission of multiple signals can be achieved under width-constrained structural conditions, while avoiding the volume expansion and interference problems of a conventional multi-harness solution.

In this embodiment, the audio apparatus 200 with a camera function further includes a rigid support strip 260 that is embedded within the package body 170, where the rigid support strip 260 is arranged side by side with the anti-interference flexible circuit board 100 in the length direction and forms a physical connection with the earhook assembly 220 and the pod assembly 230. The rigid support strip 260 is configured to structurally withstand a tensile force or bending load between the earhook assembly 220 and the pod assembly 230, such that during wearing, movement, or application of external force to the apparatus, primary mechanical stress is borne by the rigid support strip 260, thereby preventing the anti-interference flexible circuit board 100 from directly enduring tensile or bending stress. In this embodiment, the rigid support strip 260 may be a steel wire to provide sufficient tensile strength and bending rigidity without significantly increasing the thickness of the package body 170, and may extend in the length direction together with the anti-interference flexible circuit board 100 to withstand the mechanical tensile force or bending load between the earhook assembly and the pod assembly. In an alternative embodiment, the rigid support strip 260 may also be a stainless steel wire (e.g., SUS304 or SUS316) or a spring steel wire to enhance sweat corrosion resistance and long-term elastic resilience; alternatively, a titanium alloy wire may be used to maintain high specific strength while reducing weight, thereby further improving wearing comfort and fatigue durability for long-term use. By arranging the rigid support strip 260 and the anti-interference flexible circuit board 100 side by side, the anti-interference flexible circuit board 100 maintains necessary flexibility while having sufficient structural stability, thereby improving the overall reliability of the connection structure between the earhook assembly 220 and the pod assembly 230 without significantly increasing the thickness of the connection region.

In a preferred embodiment, as shown in FIG. 13, before performing the step of enclosing and sealing by the package body 170, elastic elements 280 may be pre-filled in gaps between the anti-interference flexible circuit board 100 and the earhook assembly 220 and between the anti-interference flexible circuit board and the pod assembly 230, such that the anti-interference flexible circuit board 100 forms a tight fit with the earhook assembly 220 and the pod assembly 230 without obvious gaps. The elastic element 280 may be waterproof rubber, waterproof silicone, or any other material with elasticity and waterproofness, and may be disposed on the anti-interference flexible circuit board 100 by means of coating, adhesive dispensing, or attaching. By introducing the step of filling with the elastic element 280 before the package body 170 is formed, structural gaps in the connection region can be eliminated in advance, such that the subsequently formed package body 170 can form a continuous and sealed transition interface with the earhook assembly 220, the pod assembly 230, and the anti-interference flexible circuit board 100 during enclosing, thereby reducing the risk of water seepage due to the structural gaps. Moreover, the elastic element 280 can also form a flexible buffer layer between the package body 170 and the anti-interference flexible circuit board 100 to absorb minor assembly deviations or displacement changes caused by thermal expansion and contraction, thus further enhancing the reliability and assembly tolerance of the overall sealing structure.

Through the above structural design, the anti-interference flexible circuit board 100, the rigid support strip 260, the elastic element 280, and the package body 170 cooperate in the connection region, such that not only is stable electrical connection achieved between the earhook assembly 220 and the pod assembly 230, but also an integrated connection structure with waterproofing, protection, and mechanical reinforcement functions is formed, thereby significantly improving the reliability and durability of the audio apparatus 200 with a camera function in complex usage environments.

In an alternative embodiment, the audio apparatus 200 with a camera function is a head-mounted or earhook wearable device. Specifically, for the head-mounted wearable device, the audio apparatus can be fixed to the head of the user via a headband, rear-hanging, or frame structure, and the pod assembly 230, the camera module 240, and the anti-interference flexible circuit board 100 can be arranged along the contour of the head; and for the earhook wearable device, primary functional modules of the audio apparatus 200 with a camera function can be supported and positioned near the ears of the user via the earhook assemblies 220 disposed on the outer sides of the auricles of the user. Regardless of whether the head-mounted structure or the earhook structure is adopted, the anti-interference flexible circuit board 100 serves as a flexible bridging member connecting different structural components to achieve hybrid transmission of camera signals and audio signals in a width-constrained structural space, and cooperates with the electromagnetic shielding structure, an independent ground structure, and the package body 170 to achieve stable signal transmission and reliable structural connection. Therefore, this technical solution is not limited to a specific wearing form, and its technical effects are also applicable to other wearable audio apparatuses or multifunctional wearable devices adopting similar space-constrained wiring structures.

In summary, the anti-interference flexible circuit board 100 forms a core signal channel between the functional modules in the audio apparatus 200 with a camera function. Specifically, the digital video signal from the camera module 240 is transmitted to the main control circuit board 250 for processing via a differential signal line group 121 in the anti-interference flexible circuit board 100; meanwhile, the audio drive signal output by the main control circuit board 250 is transmitted to the audio transducer 232 via an analog audio drive line group 122 in the anti-interference flexible circuit board 100 to achieve sound output; and the audio signal acquired by the microphone 234 is transmitted to the main control circuit board 250 via the electrically independent microphone ground line 141 disposed in the anti-interference flexible circuit board 100 and a corresponding signal line. During the above signal transmission, the high-speed digital video signal, the analog audio drive signal, and a weak audio acquisition signal are collectively integrated into the same flexible conductive laminated structure 110, and through the collaborative design of interlayer distribution, the reference potential layer, an electromagnetic shielding film 160, and the independent ground structure, effective isolation and stable transmission of different types of signals are achieved in a width-constrained flexible ribbon structure. Thus, the anti-interference flexible circuit board 100 not only serves a function of hybrid transmission of multiple signals, but also serves as a flexible bridging member connecting the earhook assembly 220 and the pod assembly 230, and structurally cooperates with the package body 170 and a support structure to meet the comprehensive requirements of dynamic bending, waterproof sealing, and mechanical reliability.

Therefore, through the integrated design of signal paths, electromagnetic environment, and structural connections, this technical solution achieves stable coexistence and collaborative operation of high-speed video signals and high-quality audio signals in the audio apparatus 200 with a camera function, without increasing the size or wearing burden of the apparatus, and thus has excellent engineering practicability and promotion value.

The above embodiments are only used to illustrate the technical solutions of the present disclosure, but not to limit them. While the present disclosure has been described in detail with reference to the aforementioned embodiments, those of ordinary skill in the art should understand that they can still make modifications on the technical solutions described in the aforementioned embodiments or make equivalent replacements on some of the technical features. These modifications or replacements do not make the essences of the corresponding technical solutions deviate from the spirit and scopes of the technical solutions in the various embodiments of the present disclosure, and all should be included within the scope of protection of the present disclosure.

## Claims

1. An anti-interference flexible circuit board of an audio apparatus with a camera function, comprising:
a flexible conductive laminated structure, configured as an integrated flexible ribbon structure and longitudinally divided into a mounting portion and a connecting portion, wherein the connecting portion has a width of 2 mm to 12 mm;
the flexible conductive laminated structure comprises: a first conductive layer and a second conductive layer that serve as outer signal layers, and a core layer located between the first conductive layer and the second conductive layer, wherein the first conductive layer, the core layer, and the second conductive layer are separated by an insulating medium; and
the first conductive layer and/or the second conductive layer is provided with a differential signal line group and a main clock line, the differential signal line group is used to transmit a digital video signal, the main clock line is used to synchronize clock frequencies of a master device and a slave device, and a reference potential layer is formed in at least a part of the core layer;
an electromagnetic shielding film, covering outer surfaces of the first conductive layer and the second conductive layer, such that in at least a part of the connecting portion, the core layer, the differential signal line group, and the main clock line are together wrapped in a shielding cavity formed by the electromagnetic shielding film; and
a package body, disposed on the connecting portion to enclose the flexible conductive laminated structure and form outer-layer protection,
wherein the flexible conductive laminated structure is further provided with an analog audio drive line group and an electrically independent microphone ground line, the analog audio drive line group is used to transmit a drive current to an audio transducer, and the microphone ground line is physically isolated from a main ground line network of the flexible conductive laminated structure and electrically connected to the main ground line network only at a terminal portion and/or a pad position.

2. The anti-interference flexible circuit board of an audio apparatus with a camera function according to claim 1, wherein the core layer is formed by a single conductive layer or is a composite structure formed by a plurality of internal conductive layers separated by the insulating medium.

3. The anti-interference flexible circuit board of an audio apparatus with a camera function according to claim 2, wherein when the core layer comprises the plurality of internal conductive layers, the analog audio drive line group is allocated in different internal conductive layers to increase current-carrying capacity.

4. The anti-interference flexible circuit board of an audio apparatus with a camera function according to claim 1, wherein the first conductive layer, the second conductive layer, and the core layer are all made of adhesive-free rolled copper to meet dynamic bending requirements of the connecting portion.

5. The anti-interference flexible circuit board of an audio apparatus with a camera function according to claim 1, wherein the differential signal line group comprises MCN, MCP, MDN0, and MDP0 lines for transmitting MIPI signals, and the differential signal line group is directly adjacent to the electromagnetic shielding film in a lamination direction, such that the electromagnetic shielding film absorbs high-frequency radiation nearby.

6. The anti-interference flexible circuit board of an audio apparatus with a camera function according to claim 1, wherein the analog audio drive line group has a line width of not less than 0.2 mm, and ground shielding lines with a line width of not less than 0.3 mm are disposed in parallel on both sides of the analog audio drive line group to isolate intra-layer interference.

7. The anti-interference flexible circuit board of an audio apparatus with a camera function according to claim 1, wherein the microphone ground line maintains independent routing throughout the entire length of the connecting portion of the flexible ribbon structure and is equipotentially connected to the main ground line network only at the pad position.

8. The anti-interference flexible circuit board of an audio apparatus with a camera function according to claim 1, wherein the core layer serves as a reference ground plane for the first conductive layer and the second conductive layer, and a specific dielectric thickness is configured between the differential signal line group and the core layer to control characteristic impedance.

9. The anti-interference flexible circuit board of an audio apparatus with a camera function according to claim 1, wherein the package body is made of a waterproof elastic material and hermetically encloses the flexible conductive laminated structure.

10. The anti-interference flexible circuit board of an audio apparatus with a camera function according to claim 1, wherein the flexible ribbon structure is designed in a U shape as a whole, and the length of the connecting portion is adapted to the semi-encircling dimension of an outer side of a human ear.

11. The anti-interference flexible circuit board of an audio apparatus with a camera function according to claim 1, wherein a nano waterproof coating is disposed on an outer surface of the flexible conductive laminated structure, and the nano waterproof coating is a thin film layer with a hydrophobic property.

12. A method for fabricating the anti-interference flexible circuit board of an audio apparatus with a camera function according to claim 1, comprising:
providing a core layer, wherein a reference potential layer is formed in at least a part of the core layer;
forming a first conductive layer and a second conductive layer on an upper surface and a lower surface of the core layer respectively, wherein the first conductive layer and the second conductive layer are physically isolated from the core layer by an insulating medium to form a flexible conductive laminated structure, and patterning the first conductive layer and/or the second conductive layer to form a differential signal line group and a main clock line;
attaching an electromagnetic shielding film to outer surfaces of the first conductive layer and the second conductive layer, thereby forming an electromagnetic shielding cavity that wraps the core layer, the differential signal line group, and the main clock line;
cutting the flexible conductive laminated structure covered with the electromagnetic shielding film into an integrated flexible ribbon structure, and dividing the flexible conductive laminated structure into a mounting portion and a connecting portion in a length direction, wherein the connecting portion has a width of 2 mm to 12 mm; and
forming a package body at the connecting portion to enclose the flexible conductive laminated structure and form outer-layer protection,
wherein the flexible conductive laminated structure is further provided with an analog audio drive line group and an electrically independent microphone ground line, the analog audio drive line group is used to transmit a drive current to an audio transducer, and the microphone ground line is physically isolated from a main ground line network of the flexible conductive laminated structure.

13. The method for fabricating the anti-interference flexible circuit board of an audio apparatus with a camera function according to claim 12, wherein the electrically independent microphone ground line is formed in the core layer, such that the microphone ground line maintains independent routing throughout the entire length of the connecting portion of the flexible ribbon structure and is equipotentially connected to the main ground line network only at a pad position.

14. The method for fabricating the anti-interference flexible circuit board of an audio apparatus with a camera function according to claim 12, wherein the package body is made of a waterproof elastic material and formed by means of injection molding.

15. An audio apparatus with a camera function, comprising:
a rear-hanging assembly, configured to encircle a rear side of the head of a user;
earhook assemblies, connected to both ends of the rear-hanging assembly respectively, wherein each of the earhook assemblies has a proximal end connected to the rear-hanging assembly and a distal end extending above an auricle of the user and pointing to a facial region of the user;
the anti-interference flexible circuit board according to claim 1, wherein the anti-interference flexible circuit board is connected to the distal end;
at least one pod assembly, physically connected to the distal end of the earhook assembly via the anti-interference flexible circuit board, wherein the pod assembly has a hard housing with an audio transducer accommodated inside;
a camera module, slidably connected to an outer side of the pod assembly and configured to acquire a video signal from a first-person view; and
a main control circuit board, disposed in an internal cavity of the earhook assembly,
wherein the anti-interference flexible circuit board serves as a flexible bridging member connecting the earhook assembly and the pod assembly, a connecting portion of the anti-interference flexible circuit board is threaded through the earhook assembly and is inserted into the main control circuit board, a mounting portion of the anti-interference flexible circuit board extends into the hard housing of the pod assembly and is electrically connected to the camera module, and a package body of the anti-interference flexible circuit board encloses and seals a joint between the distal end of the earhook assembly and the hard housing of the pod assembly to form outer-layer protection; and
the anti-interference flexible circuit board serves as a primary hybrid signal transmission channel for simultaneously transmitting the video signal from the camera module and an audio signal from the audio transducer.

16. The audio apparatus with a camera function according to claim 15, wherein the camera module comprises a main body portion and a flexible extension portion integrally extending from the main body portion, a redundant bending section is provided in the flexible extension portion, the redundant bending section is S-shaped, U-shaped, or wavy, and when the camera module slides relative to the pod assembly, the flexible extension portion deforms to provide an extension and contraction margin.

17. The audio apparatus with a camera function according to claim 16, wherein a connection terminal is soldered at a tail end of the flexible extension portion, and the connection terminal of the camera module is soldered and fixed to the mounting portion of the anti-interference flexible circuit board by surface mount technology, thereby achieving electrical conduction and mechanical connection between the camera module and the anti-interference flexible circuit board.

18. The audio apparatus with a camera function according to claim 16, wherein the camera module integrates an image stabilization module disposed in or on the main body portion and configured to maintain the stability of image acquisition when the camera module moves with the head of the user.

19. The audio apparatus with a camera function according to claim 15, wherein a guide rail or a sliding groove extending in a front-rear direction is formed on the outer side of the pod assembly, and the camera module is slidably connected via the guide rail or the sliding groove, thereby enabling the user to adjust a horizontal position of a shooting field of view.

20. The audio apparatus with a camera function according to claim 15, further comprising a rigid support strip that is embedded within the package body, wherein the rigid support strip is arranged alongside with the anti-interference flexible circuit board and configured to reinforce a bending shape of the flexible bridging member, and physically connects the earhook assembly and the pod assembly to withstand mechanical tension.

21. The audio apparatus with a camera function according to claim 15, wherein a connector is disposed on the main control circuit board, and the connecting portion of the anti-interference flexible circuit board is inserted into the connector.

22. The audio apparatus with a camera function according to claim 21, wherein the pod assembly is further provided with a microphone, and the microphone is connected to the connector via an independent microphone ground line of the anti-interference flexible circuit board to isolate common-ground interference.

23. The audio apparatus with a camera function according to claim 15, wherein the audio transducer is a bone conduction transducer configured to transmit sound to the skull of the user through vibration.

24. The audio apparatus with a camera function according to claim 15, wherein the audio transducer is an air conduction speaker configured to radiate sound to an ear canal of the user.

25. The audio apparatus with a camera function according to claim 15, wherein the audio apparatus with a camera function is a head-mounted or earhook wearable device.
